# EUROPEAN PATENT APPLICATION

(11) **EP 4 718 130 A1**
(43) Date of publication of application: **01.04.2026**
(21) Application number: 24202561.7
(22) Date of filing: 25.09.2024
(51) Int. Cl.: G02B 6/12, G02B 6/42

(54) **PHOTONIC DEVICE AND METHOD FOR MANUFACTURING**

(71) Applicant: LiGenTec SA, 1024 Ecublens (CH)
(72) Inventor: SACCHETTO, Davide, 1462 Yvonand, Vaud (CH); JUVERT, Joan, 9000 Gent (BE); GOYVAERTS, Jeroen, 1025 Saint-Sulpice, Vaud (CH)
(74) Representative: Isarpatent

(57) **Abstract**

The present invention provides a photonic device, comprising a photonic integrated circuit including a waveguide structure having a core layer and a cladding layer surrounding the core layer, a first cavity formed through a top surface of the photonic integrated circuit and at least partly into the cladding layer, an adhesive layer formed on at least a first surface of the first cavity, and a first photonic element arranged in the first cavity and bonded to the adhesive layer on the first surface of the first cavity, wherein at least a portion of the cladding layer and a portion of the adhesive layer define a first coupling region configured to enable coupling of an optical mode between the core layer and the first photonic element through the coupling region. Further the present invention provides a corresponding method for manufacturing a photonic device as well as.

## Description

### TECHNICAL FIELD OF THE INVENTION

The invention relates to a fiber-waveguide coupler as well as to a method for manufacturing a fiber-waveguide coupler. In particular, the invention relates to a heterogeneously integrated photonic device or integrated photonic circuit, which includes a waveguide structure on a first photonic circuit, and a photonic element as a second photonic integrated circuit arranged in a cavity of the first photonic integrated circuit and coupled to the first photonic circuit.

### TECHNICAL BACKGROUND

Photonic chips typically have at least one waveguide layer made of at least one core layer and a cladding layer. For some applications, the cladding of a first photonic chip must be partially removed in order to allow the optical signal to couple with another photonic chip that is brought into contact with the partially removed cladding. This enables for instance the insertion of photonic device, such as a III-V laser, into the locally opened cladding, allowing for light generated by the laser to be injected into the waveguide of the first photonic chip.

In a typical micro-transfer printing process, for example, a polymer material needs to be spin-coated on the surface that is required to be bound on the first chip. This however, does not work well when the surface to bond is at the bottom of an opened cavity on a first chip because the spin-coating process will lead to a very thick and non-uniform coating inside the cavity. One potential work-around is to spin-coat the surface of the second photonic chip prior to the bonding process. However, since the bonding is a sequential process and often requires a plurality of second chips to be spin-coated, such process might be prohibitively expensive.

Therefore, it is an objective of the invention to provide an improved process for integrating and coupling such second photonic chip to the waveguide structure of a first photonic chip.

US 2022/0276438 A describes a method of manufacturing of an optoelectronic device that includes a photonic component coupled to a waveguide.

### SUMMARY OF THE INVENTION

According to the invention, this problem is solved in each case by the subject matters of the independent claims.

According to a first aspect of the invention, a photonic device is provided. The photonic device comprises a photonic integrated circuit including a waveguide structure having a core layer and a cladding layer surrounding the core layer, a first cavity formed through a top surface of the photonic integrated circuit and at least partly into the cladding layer, an adhesive layer formed on at least a first surface of the first cavity, and a first photonic element arranged in the first cavity and bonded to the adhesive layer on the first surface of the first cavity, wherein at least a portion of the cladding layer and a portion of the adhesive layer define a first coupling region configured to enable coupling of an optical mode between the core layer and the first photonic element through the coupling region.

According to a second aspect of the invention, a method for manufacturing a photonic device, in particular the inventive photonic device is provided. The method for manufacturing a photonic device comprises providing a wafer comprising a photonic integrated circuit, wherein the photonic integrated circuit includes a waveguide structure having a core layer and a cladding layer surrounding the core layer, etching at least one cavity through a top surface of the photonic integrated circuit and at least partly into the cladding layer, depositing an adhesive layer onto at least a first surface of the at least one cavity, and bonding a photonic element onto the adhesive layer on the first surface of the at least one cavity such that at least a portion of the cladding layer and a portion of the adhesive layer define a coupling region that enables coupling of an optical mode between the core layer and the photonic element through the coupling region.

A fundamental concept of the present invention is to provide an adhesive with a predetermined and controlled thickness onto a surface in the cavity to enable coupling between the first photonic element and the core layer of the waveguide structure. This coupling is realized by a defined coupling region that includes at least portions of the adhesive layer with controlled thickness and the cladding layer, through which an optical mode can transfer between the core and the first phonic element.

The portions of the adhesive and the cladding layer are typically situated directly between the first photonic element and the closest position of the core layer of the waveguide structure, thereby enabling a maximum coupling efficiency. By the etching process of the cavity, the thickness of the portion of the cladding layer of the coupling region can be precisely controlled as well. Furthermore, and as mentioned above, the process for forming the adhesive layer enables to control the thickness of the adhesive layer. Therefore, the amount of coupling can be controlled by these processes precisely, enabling optimization of the coupling efficiency.

According to the method, after providing a first photonic integrated circuit including an integrated waveguide structure, which can be an appropriately coated wafer, at least a first cavity is first formed by etching a part of the cladding layer of the waveguide structure. In preferred embodiments, a plurality of cavities are formed during this etching process. As a further step, at least one surface of the cavity is coated by an adhesive. In a typical deposition process of the adhesive, all surfaces of each cavity are coated by the adhesive in this process. Then, a first photonic element, which may be a laser, a photodiode or another photonic element or photonic integrated circuit, is bonded onto the adhesive layer inside the at least one cavity. These processes are designed such that an optical mode exiting the first photonic element generally propagates through a portion of the first surface of the adhesive layer and through a portion of the cladding layer into the core layer. Due to the reversibility of light waves, an optical mode propagating in the core layer also couples to the first photonic element by crossing the same portions of the cladding layer and the adhesive layer.

A particular advantage in the solution according to an aspect of the invention is that due to a precise control of the thickness of the coupling layer, the coupling efficiency can be controlled as well. Furthermore, the manufacturing of the photonic process is provided by a relatively simple process that overcomes the problems occurring with spin coating, as described above.

According to some further embodiments of the photonic device, according to the invention, the coupling region is configured to enable evanescent coupling between the core layer of the waveguide structure and the first photonic element. According to corresponding embodiments of the method, the coupling region enables evanescent coupling between the core layer of the waveguide structure and the photonic element. The optical mode thus couples to the first photonic element by propagation of the evanescent part of the optical mode through the portion of the cladding layer and the adhesive layer on the first surface of the cavity. Due to the controlled thickness of the coupling region, i.e. the portions of the adhesive layer and the portion of the cladding layer, the thickness of the coupling layer can be tuned for optimum coupling efficiency.

According to some further embodiments of the method, the adhesive layer is formed by a chemical vapor deposition, CVD, process. The CVD process is particularly suitable to produce a uniform and very thin layer of the adhesive by conformally deposition the adhesive inside the cavity. Once this coating is performed, micro-tranfer printing of the first photonic element, which can be a III-V coupon chip such as a laser or a photodiode or another photonic device, photonic element or photonic integrated circuit, can be performed inside a cavity with well defined properties and coupling characteristics.

According to some further embodiments of the photonic device, the adhesive layer has a predetermined thickness between 1 nm and 100 nm. This is the typical range of the adhesive layer forming a coating on the first surface of the cavity. It further supports the evanescent coupling of the optical mode between the core layer and the first photonic element.

According to some further embodiments of the photonic device, the adhesive layer comprises Parylene. Preferably, the adhesive layer comprises or is composed of Parylene-C. These adhesives are particularly suitable for the above described deposition and bonding processes, providing sufficient bonding properties and a thin, uniform and precisely controlled adhesive layer thickness.

According to some further embodiments of the photonic device, the first cavity is filled with an upper cladding layer, which planarizes the first cavity with the top surface. According to corresponding embodiments of the method, the method further comprises depositing an upper cladding layer onto the top surface to planarize the at least one cavity. The upper cladding layer preferably is composed of another adhesive, which may be Paralyne, preferably Paralyne-C. The upper cladding layer mechanically stabilizes the position of the first photonic element in the first cavity, thereby ensuring a constant coupling efficiency between the first photonic element and the core layer. In this way, the robustness of the photnic device is improved.

According to some further embodiments of the photonic device, a first metallic contact connected to the first photonic element is provided in a first opening of the upper cladding. Correspondingly, according to an embodiment of the method, the step of opening at least partly the first cavity to form a first opening. This enables providing the first photonic element with electricity e.g. to run a laser or to read out a photodiode.

According to some further embodiments, the photonic device further comprises a second cavity formed through the top surface and at least partly into the cladding layer. Furthermore, a second metallic contact is provided in the second cavity. It is understood that more than two cavities with corresponding metallic contacts can be provided in a similar manner. In this way, the complexity and thus versility of the photonic device in general is increased.

According to some further embodiments of the photonic device, a second photonic element is provided in the second cavity, wherein the second photonic element is connected to the second metallic contact. Similar to the first photonic element, the second photonic element can be a III-V coupon chip such as a laser or a photodiode or another photonic device or integrated circuit, which is connected to the second metallic contact. It is understood that further photonic elements can be provided in the further cavities, or even in the same (first) cavity. Contrary, the second cavity may only be provided by an electric contact. Such an electric contact may be part of of an electrical network in the photonic integrated circuit and may function as a distribution of a voltage, such as e.g. a ground voltage to the number of photonic elements. In this way, the complexity and thus versility of the photonic device can be increased as well.

According to some further embodiments of the photonic device, the upper cladding is deposited such that the upper cladding planarizes the first cavity and the second cavity with the top surface. The first metallic contact is formed within the first opening of the upper cladding layer in the first cavity and the second metallic contact is formed in a second opening of the upper cladding layer in the second cavity. The second opening may be etched in a similar manned, preferably in the same method step, as the first cavity. In this embodiment, only the metallic contacts are visible in a view from the top surface. This is particularly useful for establishing connections between the metallic contacts or photonic element by electric conductors.

According to some further embodiments of the photonic device, electric routes are formed on the top surface for connecting the first metallic contact and the second photonic contact. These electric routes are electricly conductive and connect the first and second metallic contacts electrically.

According to some further embodiments of the method, at least a first cavity and a second cavity are etched through the top surface into the cladding layer. A first photonic element and a second photonic element are bonded into the respective first and second cavities. The upper cladding layer planarizes these first and second cavities. The method further comprises the steps of opening at least partly the first cavity and the second cavity to form first and second openings, and patterning a first metallic contact into the first opening, a second metallic contact into the second openings, and an electric route connecting the first metallic contact with the second metallic contact for forming electrical interconnections between the first photonic element and the second photonic element. Similarly, these embodiments enable further increasing the complexity and thus versility of the photonic device.

The above embodiments and further developments can be combined with each other as desired, if appropriate. In particular, all features of the photonic device are transferable to the method for manufacturing the photonic device, and vice versa. Other possible aspects, further developments and implementations of the invention also include combinations of features of the invention described above or below with regard to the embodiment examples that are not explicitly mentioned. In particular, the skilled person will also add individual aspects as improvements or additions to the respective basic form of the present invention.

Advantageous embodiments and further developments emerge from the description with reference to the figures.

### BRIEF SUMMARY OF THE DRAWINGS

The present invention is explained more specifically below on the basis of the exemplary embodiments indicated in the schematic figures, in which:
- Fig. 1: shows a schematic illustration of a photonic device according to an embodiment of the invention;
- Fig. 2: shows a schematic illustration of a photonic device according to a further embodiment of the invention;
- Fig. 3: shows a schematic illustration of a photonic device according to a further embodiment of the invention;
- Fig. 4: shows a schematic illustration of a photonic device according to a further embodiment of the invention;
- Fig. 5: shows a schematic illustration of a photonic device according to a further embodiment of the invention;
- Fig. 6: shows a schematic illustration of a photonic device according to a further embodiment of the invention; and
- Fig. 7: shows a flowchart of a method for manufacturing a photonic device according to an embodiment of the invention.

The accompanying figures are intended to convey a further understanding of the embodiments of the invention. They illustrate embodiments and are used in conjunction with the description to explain principles and concepts of the invention. Other embodiments and many of the cited advantages emerge in light of the drawings. The elements of the drawings are not necessarily shown to scale in relation to one another. Direction-indicating terminology such as for example "at the top", "at the bottom", "on the left", "on the right", "above", "below", "horizontally", "vertically", "at the front", "at the rear" and similar statements are merely used for explanatory purposes and do not serve to restrict the generality to specific configurations as shown in the figures.

In the figures of the drawing, elements, features and components that are the same, have the same function and have the same effect are each provided with the same reference signs - unless explained otherwise.

### DESCRIPTION OF EMBODIMENTS

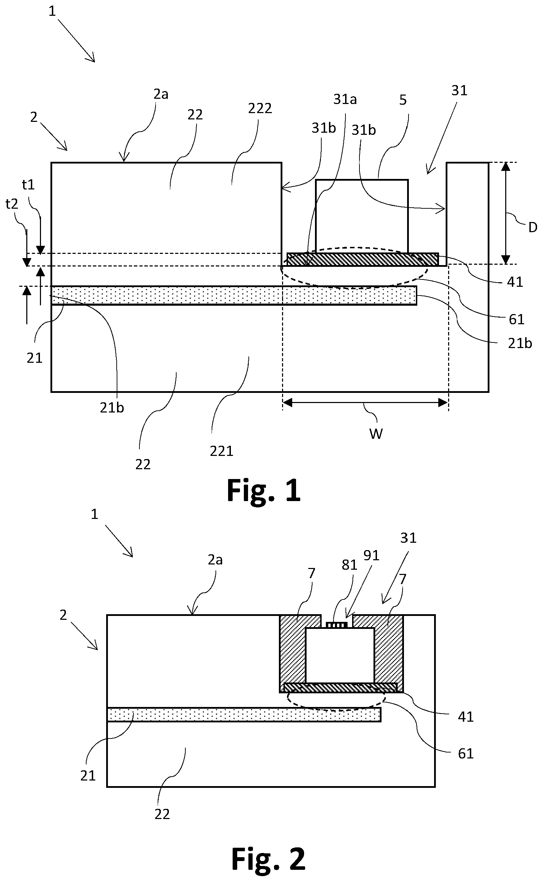

Fig. 1 shows a schematic illustration of a photonic device according to an embodiment of the invention.

Photonic device 1 shown in Fig. 1 comprises a photonic integrated circuit 2. The photonic integrated circuit includes a waveguide structure having a core layer 21 and a cladding layer 22 surrounding the core layer 21. These layers are understood in the regular meaning that an optical mode is propagating in the core layer 21, which typically has a larger index of refraction than the cladding layer 22. These layers comprises corresponding materials, such as, for example, SiO2 for the cladding layer and SiN for the core layer. Any other suitable combination of materials may be applied to the waveguide structure of the photonic integrated circuit 2. In preferred embodiments, the photonic integrated circuit 2 is provided on a wafer, which contains the cladding layer 22 and a core layer 21 in between. The wafer may thus be composed of a bottom cladding layer 221, the core layer 21 and a top cladding 222 layer, preferably formed on a substrate (not shown in Fig. 1).

In Fig. 1, the core layer 21 has a first end 21a and a second end 21b. The first end 21a illustratively may be an outside face from the photonic integrated circuit 2 and may be part of e.g. an edge coupler, coupling light from a fiber or another photonic chip into the core layer 21. In further embodiments, the first end 21a further connects to a larger photonic circuit structure comprising further photonic components. The second end 21b illustratively is surrounded by the cladding layer 22. In further embodiments, the second end 21b of the core layer 21 is not existent and the core layer 21 continuous further in the shown direction (right hand side of Fig. 2). The ends 21a and 21b are of illustrative purpose and the invention is not limited to the shown configuration and above described first and second ends 21a, 21b of the core layer.

The photonic device 1 further comprises a first cavity 31 formed by etching through a top surface 2a of the photonic integrated circuit 2 and at least partly into the cladding layer 22. In this embodiment, a part of the top cladding layer 222 is being etched to form the first cavity 31. A depth D and a width W of the first cavity 31 is controlled precisely by this etching process, e.g. within a few nm. In this embodiment, the first cavity 31 is placed above the second end 21b of the core layer 2 so that still a portion of the core layer 21 is situated below the cavity. In preferred embodiments, the first cavity 31 is formed by etching. In such processes, the thickness t2 the portion of the cladding layer 22 can be controlled precisely such that a thickness of the cladding layer 22 between the core layer 21 and the first surface 31a of the first cavity 31 is of a predetermined value, such as, for example, 50 nm or 100 nm.

The photonic device 1 further comprises an adhesive layer 41 formed on at least a first surface 31a of the first cavity 31. The first surface 31a in this example is the bottom surface of the first cavity 31. The cavity 31 has further wall surfaces 31b, which, in Fig. 1 are not covered by the adhesive layer 41. In further embodiments, the wall surfaces 31b of the first cavity 31 are also covered by the adhesive layer 41. In preferred embodiments, the adhesive layer 41 is formed by a chemical vapor deposition, CVD, process. The CVD is a process that allows a precise control of a thickness t1 of the adhesive layer 41. In some embodiments, the adhesive layer 41 has a predetermined thickness t1 between 1 nm and 100 nm, preferably 40 nm and 60 nm, more preferably about 50 nm. In further preferred embodiments, the adhesive layer 41 comprises Parylene, preferably Parylene-C, which is compatible with the process and the requirements of the thickness t1.

The photonic device 1 further comprises a first photonic element 51, which is arranged in the first cavity 31. The first photonic element 51 is bonded to the adhesive layer 41 on the first surface 3a of the first cavity 31. The first photonic element 1 may be a laser, a photodiode or another photonic element or photonic integrated circuit.

The so far described photonic structure of the photonic device 1 are arranged such that a portion of the cladding layer 22 and a portion of the adhesive layer 22 define a first coupling region 61, which is roughly indicated by the dotted ellipse shown in Fig. 1. The coupling region 61 is configured to enable coupling of an optical mode between the core layer 21 and the first photonic element 51 through the coupling region 6. The coupling and the coupling region 61 are to be understood that an optical mode propagating in the core layer 21 couples in the coupling region 61 to the first photonic element 51 so that a major fraction of its optical power, e.g. more than 50%, 60%, 70, 80, 90% or more, transfer through the coupling region 61 from the core layer 21 into the first photonic element 51, which may be a photodiode in this case. In case of a laser as the first photonic element 51, a major fraction of the optical power of the optical mode emitted by the first photonic element 51 propagates through the coupling region 61 into the core layer 21 of the photonic integrated circuit 2.

In preferred embodiments, the coupling region 61 is configured to enable evanescent coupling between the core layer 21 of the waveguide structure and the first photonic element 51. This means that the optical thickness of the coupling region 61 between the core layer 21 and the first photonic element 51 is small enough that an evanescent part of the optical mode propagating in the core layer 21 or the first photonic element 51 considerably extends into the coupling region 61 and the other of the core layer 21 or the first photonic element 51. This can be achieved by designing the optical thickness of the coupling region 61 between the core layer 21 and the first photonic element 51 by the above-mentioned manufacturing processes. A further possibility to extend the evanescent part of the optical mode into the cladding layer is by reducing the thickness (or diameter) of the core layer 21.

Fig. 2 shows a schematic illustration of a photonic device according to a further embodiment of the invention. This embodiment is based on and compatible to the previous embodiment shown in Fig. 1.

In this embodiment, the first cavity 31 is filled with an upper cladding layer 7. The upper cladding layer 7 planarizes the first cavity 31 with the top surface 2a. After the planarization, the first cavity 31 is opened, e.g. by etching, partly to form a first opening 91 above the first photonic element 51, so that the first photonic element is exposed. A first electric metallic contact 8, which is connected to the first photonic element 51, is then provided in the first opening 91 of the upper cladding 7.

In preferred embodiments, the upper cladding layer 7 includes an adhesive. In some of these embodiments, the upper cladding layer includes or consists of Parylene, preferrably Parylene-C, similar to the adhesive layer 41. In some embodiments, the adhesive is deposited by another CVD process in addition to the CVD process for deposition of the adhesive layer 41.

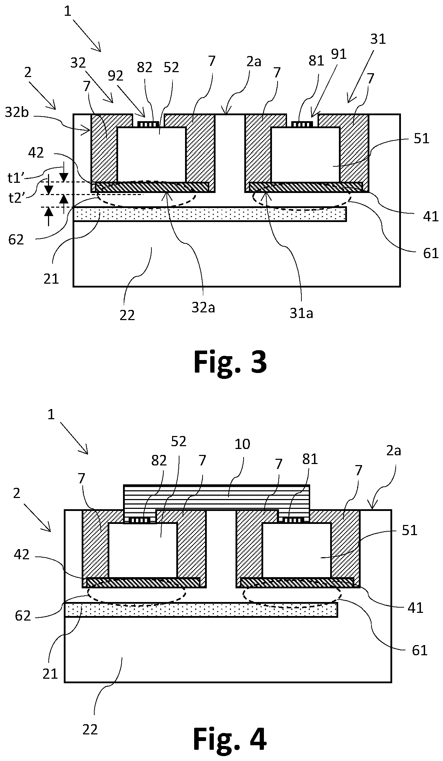

Fig. 3 shows a schematic illustration of a photonic device according to a further embodiment of the invention. This embodiment is based on and compatible to the previous embodiments shown in Fig. 1 and Fig. 2.

In this embodiment of the photonic deivce 1, a second cavity 32 is formed through the top surface 2a and at least partly into the cladding layer 22. In the second cavity 32, a second metallic contact 82 is provided in the second cavity 32. Furthermore, a second photonic element 52 is provided in the second cavity 32. The second photonic element 52 is electrically connected to the second metallic contact 82.

Similar to the previous emodiment, an upper cladding 7 is deposited such that the upper cladding 7 planarizes the first cavity 31 and the second cavity 32 with the top surface 2a. Then, at least partly the first cavity 31 and the second cavity 32 are opened again to form first and second openings 91, 92 in the respective first and second cavities 31, 32 above the respective first and second photonic elements 51, 52 to exposed these. The first metallic contact 81 is then formed within the first opening 91 of the upper cladding layer 7 in the first cavity 31. The second metallic contact 82 is formed within the second opening 92 of the upper cladding layer 7 in the second cavity 32.

Furthermore, a second coupliong region 62 enables an optical mode to couple between the second photonic element 52 and the core layer 21 by evanescent coupling. Similar to the first coupling region 61, an optical thickness of the second coupling region 62 is designed in a similar way to achieve a predetermined second coupling efficieny, which can be similar to a first coupling efficiency of an optical coupling between the first photonic element 51 and the core layer 21, or different. Thus, a thickness t2' of the portion of the cladding layer 22 within the second coupling region 62 and a thickness t1' of a second adhesive layer 42, which is disposed on a first surface 32a of the second cavity 32 and arranged between the cladding layer 22 and the second photonic element 52, may be the same or different than for the corresponding thicknesses t1, t2 of the first coupling region 61. Although in this embodiment the first and second cavities 31, 32 are drawn with the same size, these might be different. In particular, the extent of the walls 31b, 32b, i.e. the depth, or the extent of the first surfaces 31a, 32a, e.g. the width W, of the first and second cavities 31, 32 may be similar or different.

Furthermore, it is understood that the invention extends to embodiments of photonic device 1, which comprises more than two photonic elements 51, 52 included in corresponding cavities 31, 32. In such embodiments, 3, 4, 5, 10, 50, 100 or more photonic elements 51, 52 are provided in a corresponding number of cavities 31, 32 in the cladding layer 22.

Fig. 4 shows a schematic illustration of a photonic device according to a further embodiment of the invention. This embodiment is based on the embodiment described with reference to Fig. 3 and compatible to the previous embodiments shown in Fig. 1 or Fig. 2.

The structure of the photonic device 1 shown in Fig. 4 is based on the embodiment of the photonic device 1 described before and shown in Fig. 3. However, in this embodiment of the photonic device 1, electric routes 10 are formed on the top surface 2a for connecting the first metallic contact 81 and the second photonic contact 82. Such electric routes 10 are typically patterned on the top surface 2a by corresponding masks. The electric routes 10 are formed in a typically manner using a suitable metal material, for example the same metal as the electric contacts 81, 82. Such metal may can include, e.g. Cu or an copper alloy.

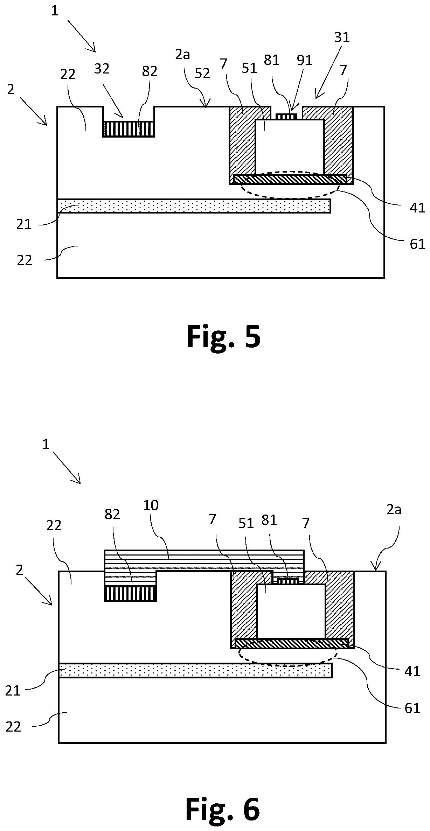

Fig. 5 shows a schematic illustration of a photonic device according to a further embodiment of the invention. This embodiment is based on the previous embodiments shown in Fig. 1 or Fig. 2 and compatible with the embodiments described in Fig. 3 and 4.

In this embodiment of the photonic device 1, a second cavity 32 is formed as well through the top surface 2a and at least partly into the cladding layer 22.

Furthermore, a second metallic contact 82 is provided in the second cavity 32. However, the second cavity 32 does not include the second photonic element 52. In this embodiment, the second electric contact 82 merely functions as a distribution of a voltage, such as a ground voltage to a number of photonic elements 51, 52, of which only the first photonic element 51 is shown in Fig. 5. In some embodiments, the number of photonic devices 51, 52 is more than two, three, five, 10 or 100, which results in a complex photonic device 1.

Fig. 6 shows a schematic illustration of a photonic device according to a further embodiment of the invention. This embodiment is based on and compatible to the previous embodiments shown in Fig. 1 to Fig. 5.

The structure of the photonic device 1 shown in Fig. 6 is based on the embodiment of the photonic device 1 described before and shown in Fig. 5. Here as well, electric routes 10 are formed on the top surface 2a for connecting the first metallic contact 81 and the second photonic contact 82.

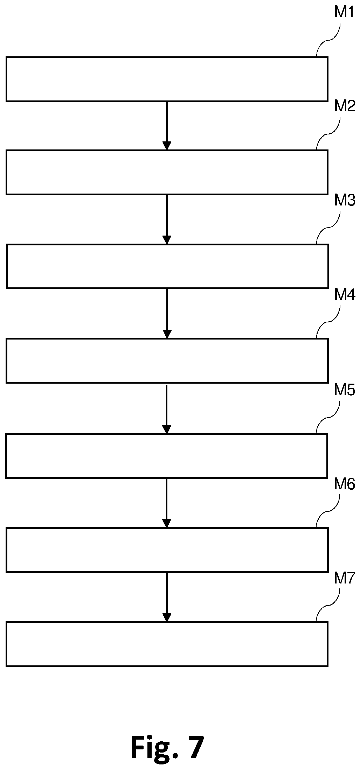

Fig. 7 shows a flowchart of a method for manufacturing a photonic device according to an embodiment of the invention.

The method for manufacturing a photonic device 1 is suitable to manufacture the photonic device 1 described so far.

At first, a wafer comprising a photonic integrated circuit 2 is provided M2. The photonic integrated circuit 2 includes a waveguide structure having a core layer 21 and a cladding layer 22 surrounding the core layer 21. The wafer may thus comprise a bottom cladding layer 221 arranged directly below the core layer 21 and a top cladding layer 222 arranged directly above the core layer 21.

In a further step, at least one cavity 31, 32 is etched M1 through a top surface 2a of the photonic integrated circuit 2 and at least partly into the cladding layer 22. A depth D and a width W of the first cavity 31 is controlled precisely by this etching process, e.g. within a few nm.

Further, an adhesive layer 41, 42 is deposited M3 onto at least a first surface 31a, 32a of the at least one cavity 31, 32. In preferred embodiments, the adhesive layer 41, 42 is formed by a chemical vapor deposition, CVD, process.

In another step, a photonic element 51, 52 is bonded M4 onto the adhesive layer 41, 42 on the first surface 31a, 32a of the at least one cavity 31, 32. By this bonding and the previous etching, at least a portion of the cladding layer 22 and a portion of the adhesive layer 41, 42 define a coupling region 61, 62 that enables coupling of an optical mode between the core layer 21 and the photonic element 51, 52 through the coupling region 61, 62. In preferred embodiments, the coupling region 61, 62 enables evanescent coupling between the core layer 21 of the waveguide structure and the photonic element 51, 52.

In a further, optional, step, an upper cladding layer 7 is deposited M5 onto the top surface 2a to planarize the at least one cavity 31, 32.

In a further preferred embodiment, at least a first cavity 31 and a second cavity 32 are etched in step M3. In these first and second cavities 31, 32, a first photonic element 51 and a second photonic element 52 are bonded in the fourth step M4. In some of these embodiments, the first and second cavities 31, 32 are planarized with the top surface 2a by the upper cladding layer 7.

In further preferred embodiments of the method, at least partly the first cavity 31 and the second cavity 32 are opened M5 to form first and second openings 91, 92 directly above the first and second photonic elements 51, 52. Then, a first metallic contact 81 is patterend into the first opening 91, a second metallic contact 82 is patterend into the second openings 92, and an electric route 10 connecting the first metallic contact 81 with the second metallic contact 82 is formed to establish electrical interconnections between the first photonic element 51 and the second photonic element 52. This patterning is performed on the top surface 2a, e.g. by using suitable masks.

In the detailed description above, various features have been combined in one or more examples in order to improve the rigorousness of the illustration. However, it should be clear in this case that the above description is of merely illustrative but in no way restrictive nature. It serves to cover all alternatives, modifications and equivalents of the various features and exemplary embodiments. Many other examples will be immediately and directly clear to a person skilled in the art on the basis of his knowledge in the art in consideration of the above description.

The exemplary embodiments have been chosen and described in order to be able to present the principles underlying the invention and their application possibilities in practice in the best possible way. As a result, those skilled in the art can optimally modify and utilize the invention and its various exemplary embodiments with regard to the intended purpose of use. In the claims and the description, the terms "including" and "having" are used as neutral linguistic concepts for the corresponding terms "comprising". Furthermore, use of the terms "a", "an" and "one" shall not in principle exclude the plurality of features and components described in this way.

While at least one exemplary embodiment of the present invention(s) is disclosed herein, it should be understood that modifications, substitutions and alternatives may be apparent to one of ordinary skill in the art and can be made without departing from the scope of this disclosure. This disclosure is intended to cover any adaptations or variations of the exemplary embodiment(s). In addition, in this disclosure, the terms "comprise" or "comprising" do not exclude other elements or steps, the terms "a" or "one" do not exclude a plural number, and the term "or" means either or both. Furthermore, characteristics or steps which have been described may also be used in combination with other characteristics or steps and in any order unless the disclosure or context suggests otherwise. This disclosure hereby incorporates by reference the complete disclosure of any patent or application from which it claims benefit or priority.

### LIST OF USED REFERENCE SIGNS

- 1: photonic device
- 2: photonic integrated circuit
- 2a: top surface of the photonic integrated circuit
- 7: upper cladding layer
- 21: core layer
- 22: cladding layer
- 221: bottom cladding layer
- 222: top cladding layer
- 31: first cavity
- 31a: first surface of the cavity
- 31b: wall surface of the cavity
- 41: (first) adhesive layer in the first cavity
- 42: (second) adhesive layer in the second cavity
- 51: first photonic element
- 52: second photonic element
- 61: (first) coupling region
- 62: (second) coupling region
- 81: first metallic contact
- 82: second metallic contact
- 91: first opening
- 92: second opening
- D: depth of the first cavity
- M1-M7: method step
- t1, t1': thickness of the adhesive layer
- t2, t2': thickness of the portion of the cladding layerW width of the first cavity

## Claims

1. Photonic device (1), comprising
a photonic integrated circuit (2) including a waveguide structure having a core layer (21) and a cladding layer (22) surrounding the core layer (21),
a first cavity (31) formed through a top surface (2a) of the photonic integrated circuit (2) and at least partly into the cladding layer (22),
an adhesive layer (41) formed on at least a first surface (31a) of the first cavity (31), and
a first photonic element (51) arranged in the first cavity (31) and bonded to the adhesive layer (41) on the first surface (3a) of the first cavity (31),
wherein at least a portion of the cladding layer (22) and a portion of the adhesive layer (22) define a first coupling region (61) configured to enable coupling of an optical mode between the core layer (21) and the first photonic element (51) through the coupling region (6).

2. Photonic device (1) according to claim 1, wherein the coupling region (61) is configured to enable evanescent coupling between the core layer (21) of the waveguide structure and the first photonic element (51).

3. Photonic device (1) according to claim 1 or 2, wherein the adhesive layer (41) has a predetermined thickness (t1) between 1 nm and 100 nm.

4. Photonic device (1) according to any of the preceding claims, wherein the adhesive layer (41) comprises Parylene, in particular Parylene-C.

5. Photonic device (1) according to any of the preceding claims, wherein the first cavity (31) is filled with an upper cladding layer (7), which planarizes the first cavity (31) with the top surface (2a), wherein the upper cladding layer (7) preferably includes an adhesive, in particular Parylene.

6. Photonic device (1) according to claims 5, wherein a first metallic contact (8) connected to the first photonic element (51) is provided in a first opening (91) of the upper cladding (7).

7. Photonic (1) device according to any of the preceding claims, further comprising a second cavity (32) formed through the top surface (2a) and at least partly into the cladding layer (22), wherein a second metallic contact (82) is provided in the second cavity (32).

8. Photonic device (1) according to claim 7, wherein a second photonic element (52) is provided in the second cavity (32), wherein the second photonic element (52) is connected to the second metallic contact (82).

9. Photonic device according to claims 7 or 8 and claim 6, wherein the upper cladding (7) is deposited such that the upper cladding (7) planarizes the first cavity (31) and the second cavity (32) with the top surface (2a), wherein the first metallic contact (81) and the second metallic contact (82) are formed within the first opening (91) of the upper cladding layer (7) in the first cavity (31) and a second opening (92) of the upper cladding layer (7) in the second cavity (32).

10. Photonic device according to any of claims 7 to 9 and claim 6, wherein electric routes (10) are formed on the top surface (2a) for connecting the first metallic contact (81) and the second photonic contact (82).

11. Method for manufacturing a photonic device (1), in particular a photonic device (1) according the precedent claims, comprising
providing (M1) a wafer comprising a photonic integrated circuit (2), wherein the photonic integrated circuit (2) includes a waveguide structure having a core layer (21) and a cladding layer (22) surrounding the core layer (21),
etching (M2) at least one cavity (31, 32) through a top surface (2a) of the photonic integrated circuit (2) and at least partly into the cladding layer (22),
depositing (M3) an adhesive layer (41, 42) onto at least a first surface (31a, 32a) of the at least one cavity (31, 32), and
bonding (M4) a photonic element (51, 52) onto the adhesive layer (41, 42) on the first surface (31a, 32a) of the at least one cavity (31, 32) such that at least a portion of the cladding layer (22) and a portion of the adhesive layer (41, 42) define a coupling region (61, 62) that enables coupling of an optical mode between the core layer (21) and the photonic element (51, 52) through the coupling region (61, 62).

12. Method according to claim 11, wherein the coupling region (61, 62) enables evanescent coupling between the core layer (21) of the waveguide structure and the photonic element (51, 52).

13. Method according to claims 11 or 12, wherein the adhesive layer (41, 42) is formed by a chemical vapor deposition, CVD, process.

14. Method according to any of claims 11 to 13, further comprising, depositing (M5) an upper cladding layer (7) onto the top surface (2a) to planarize the at least one cavity (31, 32).

15. Method according to claim 14, wherein at least a first cavity (31) and a second cavity (32) are etched, in which a first photonic element (51) and a second photonic element (52) are bonded, and which are planarized by the upper cladding layer (7), further comprising:
opening (M6) at least partly the first cavity (31) and the second cavity (32) to form first and second openings (91, 92), and
patterning (M7) a first metallic contact (81) into the first opening (91), a second metallic contact (82) into the second openings (92), and an electric route (10) connecting the first metallic contact (81) with the second metallic contact (82) for forming electrical interconnections between the first photonic element (51) and the second photonic element (52).
